# EUROPEAN PATENT APPLICATION

(11) **EP 1 381 261 A2**
(43) Date of publication of application: **14.01.2004**
(21) Application number: 02256876.0
(22) Date of filing: 03.10.2002
(51) Int. Cl.: H05K 3/38, H05K 3/46, H05K 3/02

(54) **Thin-sheet resin-coated carrier**

(30) Priority: 09.07.2002 CN 02141393
(71) Applicant: Ultratera Corporation, Hsin-Chu (TW)
(72) Inventor: Yu, Ching-I, Bade City, Taoyuan (TW); Chih, Lang-Ching, Gueishan Shiang, Taoyuan (TW); Liu, Kang-Tsun, Juan Jen, Miaoli (TW); Yen, Kung-Ming, Pingjen City, Taoyuan (TW)
(74) Representative: O'Connell, David Christopher

(57) **Abstract**

A resin-coated carrier having a sheet-like base, the sheet-like base corresponding to the shape of a PC board substrate on a relatively smaller scale, and a resin of a predetermined thickness covered over one side of the sheet-like base for bonding to a PC board substrate for making a PC board without causing an overflow of the resin.

## Description

### BACKGROUND OF THE INVENTION

### 1. Field of the Invention:

The present invention relates to a resin-coated carrier for making a printed circuit board and, more particularly to a thin-sheet resin-coated carrier.

### 2. Description of the Related Art:

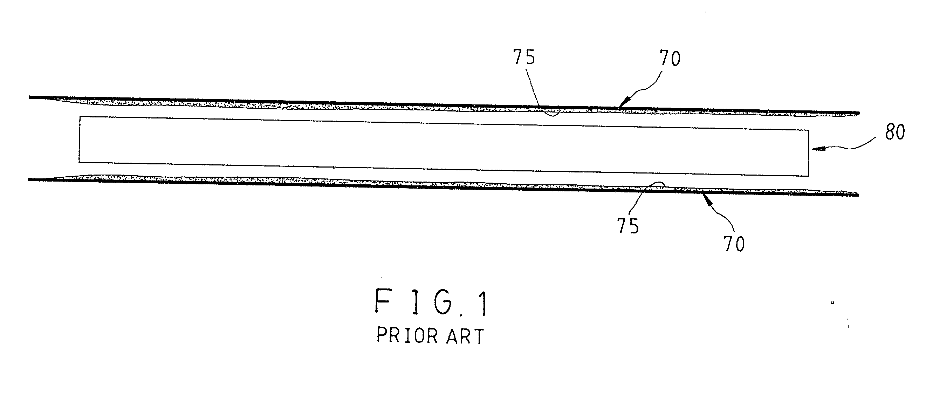

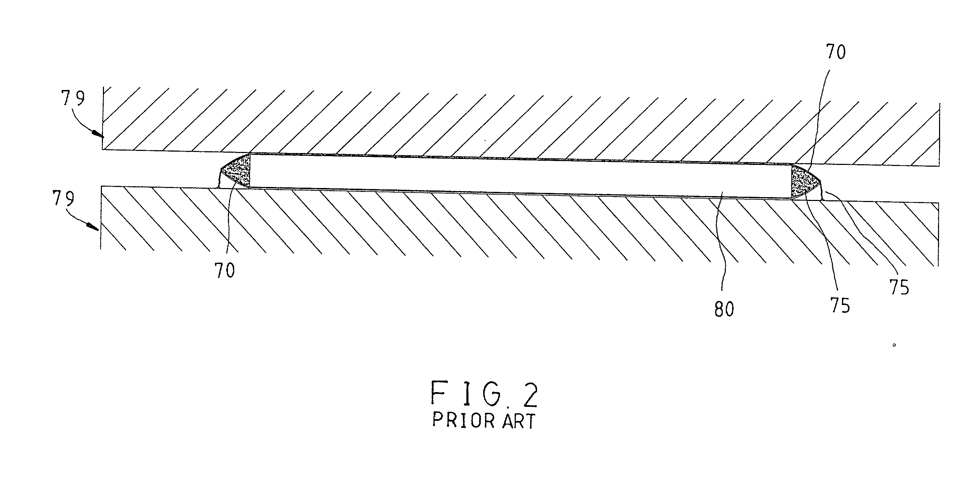

A regular resin-coated carrier **70** for making a printed circuit board, as shown in FIG. 1, is made of copper foil and covered with a layer of resin **75**. When making a PC board, two resin-coated carriers **70** are respectively adhered to the top and bottom sides of a PC board substrate **80.** As illustrated in FIG. 2, two planar tools (mirror plates) **79** are pressed on the resin-coated carriers **70** against the top and bottom sides of the PC board substrate **80** and heated, thereby causing the resin **75** of the resin-coated carriers **70** to be respectively bonded to the top and bottom sides of the PC board substrate **80.** After bonding, the excessive part of the resin-coated carriers **70** is cut away, and then the PC board substrate with the bonded resin-coated carriers **70** are processed through an etching process to form the desired circuitry. This design of resin-coated carriers has drawbacks. When squeezing the mirror plates **79** against the resin-coated carriers **70** and the PC board substrate **80,** a small amount of the melted resin flows out of the top and bottom sides of the PC board substrate **80,** thereby causing the resin-coated carriers **70** to be peripherally bonded to each other around the PC board substrate **80.** When the resin-coated carriers **70** peripherally bonded together, the follow cutting procedure becomes complicated. Furthermore, the overflow of resin may contaminate the mirror plates **79**. The procedure of removing adhered resin from the mirror plates **79** may cause damage to the surface of the mirror plate **79.** In order to facilitate removal of an overflow of resin, a release film (not shown) may be used and set between the resin-coated carrier **70** and the corresponding lens board **79** for absorbing the resin. The use of the release film greatly increases the PC board manufacturing cost.

### SUMMARY OF THE INVENTION

The present invention has been accomplished under the circumstances in view. It is the main object of the present invention to provide a resin-coated carrier, which does not cause the resin to flow out when bonded to the PC board substrate. It is another object of the present invention to provide a resin-coated carrier, which does not contaminate the mirror plates when bonding to the PC board substrate. It is still another object of the present invention to provide a resin-coated carrier, which eliminates the use of a release film when bonding to the PC board substrate. To achieve these and other objects of the present invention, the resin-coated carrier comprises a sheet-like base, a sheet-like base, having one bonding area in one side thereof, said bonding area of said sheet-like base corresponding to the shape of said PC board substrate on a relatively smaller scale, and a resin of a predetermined thickness covered over said bonding area for bonding to a respective PC board substrate for making a PC board. According to the embodiment of the present invention, the sheet-like base is made subject to the shape of the PC board substrate on a relatively smaller scale, having only one bonding area covered with the resin. According to the second embodiment, the base is a roll of sheet material having longitudinally equally spaced bonding areas respectively covered with the resin. Each bonding area has the shape of the PC board substrate on a relatively smaller scale.

### BRIEF DESCRIPTION OF THE DRAWINGS

FIG. 1 is a schematic drawing showing the arrangement of two resin-coated carriers at two sides of a PC board substrate according to the prior art.
FIG. 2 is a schematic drawing showing two resin-coated carriers bonded to top and bottom sides of a PB board substrate and resin flowed out of the PB board substrate according to the prior art.
FIG. 3 is a perspective view of a resin-coated carrier constructed according to the first embodiment of the present invention.
FIG. 4 is a schematic drawing showing two resin-coated carriers squeezed between two lens boards and bonded to top and bottom sides of a PC board substrate according to the present invention.
FIG. 5 is a perspective view of a resin-coated carrier constructed according to the second embodiment of the present invention.

### DETAILED DESCRIPTION OF THE PREFERRED EMBODIMENT

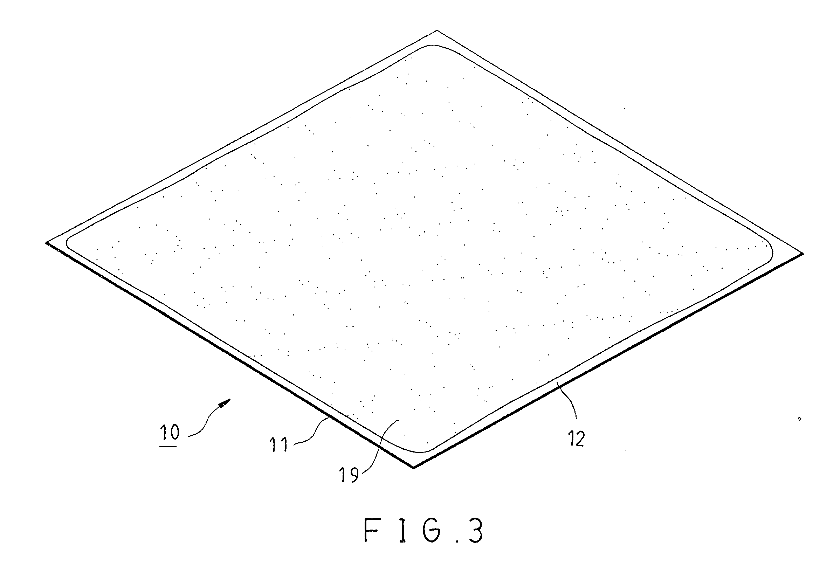

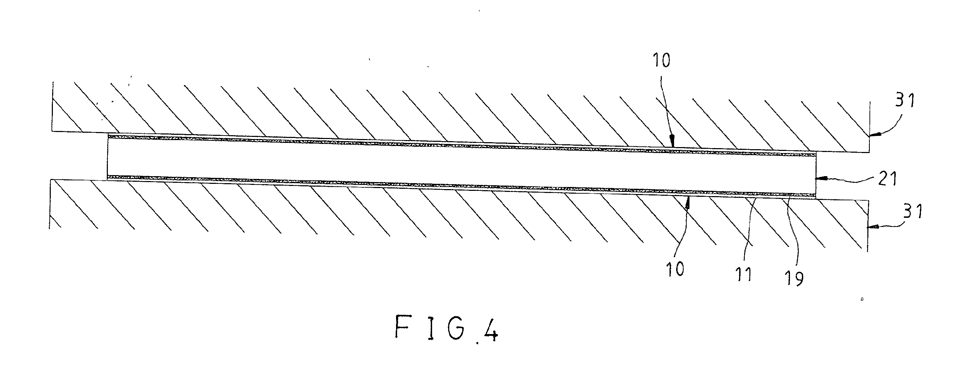

Referring to FIGS. 3 and 4, a resin-coated carrier **10** is adapted for adhering to a PC board substrate **21,** which is made of electrically insulating material. The resin-coated carrier **10** is a resin coated copper foil comprising a sheet-like base **11** corresponding to the shape of the PC board substrate **21**, a resin **19** uniformly covered over one side, namely, the bonding side **12** of the sheet-like base **11** subject to a predetermined thickness. When the sheet-like base **11** adhered to the PC board substrate **21,** the PC board substrate **21** covers the area of the resin **19**.

Referring to FIG. 4 again, two resin-coated carriers **10** are respectively attached to the top and bottom sides of the PC board substrate **21,** and then two mirror plates **31** are respectively pressed on the copper foils of the resin-coated carriers **10** when heating, causing the resin **19** of each resin-coated carrier **10** to be respectively bonded to the top and bottom sides of the PC board substrate **21**. Because the resin-coated carriers **10** have the shape of the PC board substrate **21** on a relatively smaller scale and the resin **19** of each resin-coated carrier **10** does not cover the whole area of the corresponding side (the top side or bottom side) of the PC board substrate **21**, the resin **19** of each resin-coated carrier **10** does not flow out of the PC board substrate **21** when squeezing the mirror plates **31** against the resin coated carriers **10** and the PC board substrate **21** to force the resin **19** of each resin-coated carrier **10** to spread outwards, i.e., the resin-coated carrier **10** eliminates the resin overflow problem when adhering to the PC board substrate as encountered in the prior art designs.

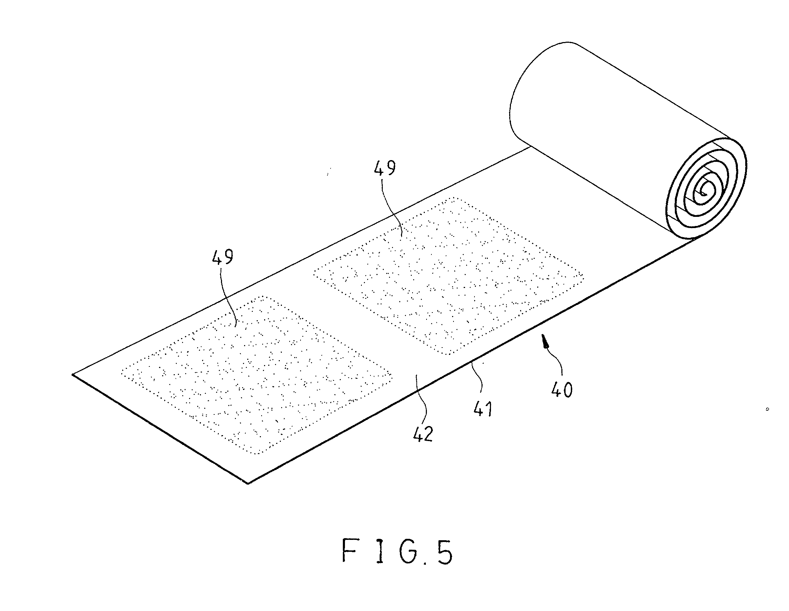

FIG. 5 shows an alternate form of the present invention. The resin-coated carrier **40** comprises a long, narrow sheet of base **41** and a resin **49** covered on one side, namely, the bonding side **42** of the base **41** at equally longitudinally spaced areas. Each resin **49** coated area of the bonding side **42** has the shape of the PC board substrate (not shown) on a relatively smaller scale. Because the resin **49** is not sticky, the resin-coated carrier **40** can be rolled up into a roll. The resin-coated carrier **40** is cut into units before use. The use of the cut units is same as the embodiment shown in FIGS. 3 and 4.

In the aforesaid two embodiments, the base **11** or **41** is made of copper foil. Alternatively, the base **11** or **41** can be made of polyethylene terephthalate film or any of a variety of sheet materials suitable for making printed circuit boards.

As indicated above, the resin **19** does not flow out of the PC board substrate **21** during lens board pressing and heating procedure, preventing bonding of the copper foils of the resin-coated carriers or contamination to the mirror plates **31.** besides, the present invention doesn't need the application of release film. In general, the invention eliminates the drawbacks of the prior art designs.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A resin-coated carrier for being disposed on a PC board substrate, said carrier comprising: a sheet-like base, having one bonding area in one side thereof, said bonding area of said sheet-like base corresponding to the shape of said PC board substrate on a relatively smaller scale, and a resin of a predetermined thickness covered over said bonding area for bonding to a respective PC board substrate for making a PC board.

2. The resin-coated carrier as claimed in claim 1, wherein said sheet-like base is in the shape of rectangle.

3. The resin-coated carrier as claimed in claim 1, wherein said sheet-like base is a roll of sheet material having a plurality of longitudinally equally spaced bonding areas in one side.
